# EUROPEAN PATENT APPLICATION

(11) **EP 1 024 022 A1**
(43) Date of publication of application: **02.08.2000**
(21) Application number: 99925281.0
(22) Date of filing: 27.05.1999
(51) Int. Cl.: B41N 1/24, B41C 1/14

(54) **PLATE FOR SCREEN PRINTING AND METHOD FOR MANUFACTURING THE SAME**

(30) Priority: 28.05.1998 JP 14807698
(71) Applicant: MATSUSHITA ELECTRIC INDUSTRIAL CO., LTD., Kadoma-shi, Osaka 571-8501 (JP)
(72) Inventor: OCHI, Hiroshi, Saijo-shi, Ehime 793-0043 (JP); BABA, Yasuyuki, Saijo-shi, Ehime 793-0002 (JP); SEGAWA, Shigetoshi, Niihama-shi, Ehime 792-0050 (JP); SHIGEMI, Jun, Saijo-shi, Ehime 793-0043 (JP); MURAKAMI, Taizo, Aichi 497-0014 (JP); NAGAO, Fumitaka, Sakura-shi, Chiba 285-0863 (JP)
(74) Representative: Eisenführ, Speiser & Partner
(86) International application number: JP9902789
(87) International publication number: WO9961253

(57) **Abstract**

The present invention provides:
a screen printing plate that is produced through an easy punching process at low costs in a short period, and that makes it possible to easily carry out a printing process even on a base member such as a semiconductor wafer that is susceptible to scratches;
a screen printing plate characterized in that a sheet made of at least one kind of resin selected from the group consisting of polyimide resins, polyetherimide resins and polyphenylenesulfide resins is subjected to a punching process by a numerically controlled punching machine, and is set on or over, or in a screen frame; and
a manufacturing method of a screen printing plate characterized in that, after a sheet made from at least one kind of resin selected from the group consisting of polyimide resins, polyetherimide resins and polyphenylenesulfide resins is set on or over, or in a screen frame, the resin sheet is subjected to a punching process by a numerically controlled punching machine, or after the sheet is clamped along its peripheral portion with a tension being applied thereto, the resin sheet is subjected to a punching process by a numerically controlled punching machine, and then set on or over, or in a screen frame.

## Description

### FIELD OF THE INVENTION

The present invention relates to a screen printing plate used for screen printing, such as solder printing, embedding paste printing, dot printing and various insulating material printing, and a manufacturing method for such a printing plate.

### PRIOR ART

In recent years, along with miniaturization of electronic devices and electronic parts, there are ever-increasing demands for miniaturized printed boards installed therein and for chip parts having narrowed pitches which are assembled in such a printed board.

Conventionally, with respect to the assembling method for these chip parts having narrowed pitches, the solder printing using a metal mask mainly manufactured by an electro-forming method has been adopted.

However, although the metal mask, manufactured by such an electro-forming method, is superior in precision of the aperture width and the aperture section, it requires high costs and long time, since metal layers have to be stacked by an electroplating method.

In order to improve such a metal mask, Japanese Laid-Open Patent Application No. 81027/1995 has disclosed a method in which: holes are formed in a plastic sheet by using an exima laser machining device and this is used as a solder printing plate.

However, since the hole-forming process in the plastic sheet by using the exima laser requires a metal mask that is symmetrical with a pattern to be formed, the metal mask having a symmetrical shape to the pattern needs to be prepared beforehand, and since the exima laser machining device used in this process is expensive, it is not possible to produce the plate at low costs in a short period.

Another method has been known in which a drill is used for machining and drilling a substrate made from a thermo-setting resin such as phenol resin.

However, the method of this type using a drill for machining takes much time, and fails to provide holes in an efficient manner.

Another known method is to use a punching machine for forming holes in the metal mask.

The metal mask through which holes are made by the punching machine has been used for normal patterns in some cases, although this has not been applied to QFP patterns having narrow pitches. However, the punching machine is slow in machining speeds, and as compared with the multi-punching machine, it has disadvantages in machining speeds and formation of fine patterns.

Recently, an attempt has been made to print various insulating materials on a base member, such as a semiconductor wafer, the surface of which is susceptible to scratches. In such a printing process, metal masks have been conventionally used; however, because of the semiconductor wafer susceptible to scratches, a special printing technique has been required. Instead of the metal masks, mesh screens which are less susceptible to scratches are sometimes adopted; however, since the mesh is located at the screen aperture section, bubbles tend to enter paste during the printing.

### PROBLEMS TO BE SOLVED BY THE INVENTION

The object of the present invention is to solve the above-mentioned problems on the metal masks produced by electroforming and plastic masks produced by exima laser machining, and to produce and provide the plate at low costs in a short time.

Another object of the present invention is to provide a printing plate that are free from those problems on the conventional metal masks and mesh screens, even when used in printing various insulating materials, etc. on a base member such as a semiconductor wafer that is susceptible to scratches.

### MEANS FOR SOLVING THE PROBLEMS

The inventors of the present invention have earnestly studied in order to solve the above-mentioned problems, and found that when a specific device is used to make holes in a specific resin sheet, it becomes possible to obtain a screen printing plate at low costs in a short time; thus, based upon this finding, the present invention has been completed.

In other words, a screen printing plate of the present invention is characterized in that a resin sheet, made from at least one kind of resin selected from the group consisting of polyimide resins, polyetherimide resins and polyphenylenesulfide resins, is subjected to a punching process by a numerically controlled punching machine, and is set in a screen frame.

Another manufacturing method of a screen printing plate of the present invention is characterized in that after a sheet, made from at least one of resin selected from the group consisting of polyimide resins, polyetherimide resins and polyphenylenesulfide resins, has been set in a screen frame, the resin sheet is subjected to a punching process by a numerically controlled punching machine.

Still another manufacturing method of a screen printing plate of the present invention is characterized in that after a sheet, made from at least one of resin selected from the group consisting of poly imide resins, polyether imide resins and polyphenylenesulfide resins, has been clamped at its peripheral portion with a tension being applied thereto, the resin sheet is subjected to a punching process by a numerically controlled punching machine, and then set in a screen frame.

### EMBODIMENT OF THE INVENTION

### [I] Screen printing plate

### (1) Constituent materials

### (a) Resin sheet

With respect to the resin sheet used in the manufacturing process of the screen printing plate of the present invention, a sheet, which is made from at least one kind of resin selected from the group consisting of polyimide resins, polyetherimide resins and polyphenylenesulfide resins, is used.

Among these resins, polyimide resins and polyphenylenesulfide resins are preferably used.

In general, the resin sheet has a thickness of 30 to 1,000µm, preferably 75 to 350µm.

Metal, such as aluminum, nickel and titanium, may be laminated on the surface of each of these resin sheets with a thickness up to several microns by using a method such as vapor deposition, sputtering and plating; thus, this laminated film may be used.

With respect to the size of holes formed in the resin sheet, it is set to various sizes depending on the purposes of a screen printing plate to be prepared; however, in general, the diameter or the length is set in the range of 0.01 to 50 mm, preferably in the range of 0.05 to 10 mm.

The numerically controlled punching machine can accurately punch the sheet at high speeds to form holes having various shapes, such as a round shape like a circle or an elliptical shape, a polygonal shape like a triangle, a square, a rectangular shape, a hexagon, etc., and a combination thereof. As long as this object is achieved, the resin sheet may have a construction in which resin films, made from polyester resin, such as, for example, polyethyleneterephthalate (PET), may be laminated. In this case, the total thickness is adjusted in the above-mentioned range.

### (b) Screen frame

With respect to the screen frame used in the present invention, those made of various materials such as wood and metal like aluminum, stainless steel, and steel are used in general. From the viewpoint of strength, light weight, corrosion resistance, etc., a square or rectangular frame, formed by machining an extruded aluminum member, is normally used.

### (c) Mesh textile

When the resin sheet may be directly set on the screen frame, no mesh textile is required; however, it is preferable for the resin sheet to be set in the screen frame through the intermediary of mesh textile that is made of polyester, stainless steel, nylon, polyethylene or a composite matter of these.

### (2) Construction

In the screen printing plate of the present invention, a sheet, made from at least one kind of resin selected from the group consisting of polyimide resins, polyetherimide resins and polyphenylenesulfide resins, is subjected to a punching process by a numerically controlled punching machine, and is directly set on a screen frame, or set in it through the intermediary of mesh textile that is made of polyester, stainless steel, nylon, polyethylene or a composite thereof. When the resin sheet is set in the screen frame through the intermediary of the mesh textile and when the mesh textile is not interpolated over the holes of the resin sheet, it is possible to avoid bubbles from entering the paste during the printing process.

### [II] Manufacturing method of the screen printing plate

When the screen printing plate of the present invention is manufactured, the resin sheet is directly set on or over, or in the screen frame, and the resin sheet is subjected to a punching process by a numerically controlled punching machine. Alternatively, the resin sheet is clamped along its peripheral portion with a tension being applied thereto, it is subjected to a punching process by a numerically controlled punching machine, and then set on or over, or in the screen frame.

Preferably, the above-mentioned resin sheet is set in the screen frame through the intermediary of mesh textile that is made of polyester, stainless steel, nylon, polyethylene or a composite thereof.

The following description will discuss how the resin sheet is set in the screen frame through the intermediary of the mesh textile. First, a mesh stretching process is carried out in which the mesh textile is stretched on or over the screen frame, and a mesh-textile affixing process is performed in which the resin sheet is affixed onto the mesh textile. Next, a resin sheet stretching process is carried out in which the resin sheet is stretched on or over the screen frame through the mesh textile, and a punching process of the resin sheet is performed in which the resin sheet is subjected to a punching process by using a numerically controlled punching machine. Alternatively, first the peripheral portion of the resin sheet is clamped, and with a tension being given to the resin sheet, a punching process of the resin sheet is carried out in which the resin sheet is subjected to a punching process by using a numerically controlled punching machine, while in an independent manner, a mesh textile stretching process is performed in which the mesh textile is stretched on or over the screen frame. Thereafter, a mesh textile affixing process is carried out in which the resin sheet is affixed onto the mesh textile, and a resin-sheet stretching process is performed in which the resin sheet is stretched on or over the screen frame through the mesh textile.

More specifically, in the case where the resin sheet is subjected to the punching process after it has been stretched on or over the screen frame, the following processes (1) through (4) are taken; and in the case where the resin sheet is stretched on or over the screen frame after it has been subjected to the punching process, the following processes (i) to (iv) are taken:

### Method for punching the resin sheet after it has been stretched on or over the screen frame

### (1) Mesh textile stretching process

In the stretching process for gauze-stretching the mesh textile on or over the screen frame, any known method may be used; and in general, this is carried out by using a gauze-stretching device such as an air stretcher gauze-stretching device.

With respect to the tension applied to the mesh textile, it is generally set in the range of 0.5 to 2.0 mm, preferably 1.0 to 1.5 mm, when measured by a tension gauge (STG-75B made by Tokyo Process Service K.K.).

Then, in order to fix the mesh textile onto the screen frame, in general, a bonding agent is applied between the two members, and since it takes normally 5 to 60 minutes for the bonding agent to set, the joined state is maintained as it is for such a period.

With respect to the bonding agent, any bonding agent may be used as long as it allows fixing; and in general, rubber-based bonding agents, etc. are used.

### (2) Mesh textile affixing process

To the mesh textile that has been gauze-stretched on or over the screen frame is applied a bonding agent on the periphery of the center thereof except the peripheral portion of the mesh textile adjacent to the screen frame, and on this central portion of the mesh textile is laminated a sheet that is made of at least one kind of resin selected from the group consisting of polyimide resins, polyetherimide resins and polyphenylenesulfide resins, and this is pressed and held for a predetermined period of time so as to be joined thereto.

With respect to the bonding agent, any bonding agent may be used as long as it allows fixing; and in general, epoxy-based bonding agents, etc. are used.

When the bonding agent is applied and set, the superposed state is normally maintained for approximately 5 minutes to 24 hours so as to allow the bonding agent to set.

### (3) Resin sheet stretching process

A portion (central portion), which is located inside the bonding agent-applied portion in the mesh textile on which the resin sheet has been laminated, is cut out so that the resin sheet is stretched in the screen frame through the intermediary of the mesh textile.

In the case where the resin sheet is directly stretched on or over the screen frame without through the mesh textile being interposed, in place of the mesh textile used in the mesh textile stretching process (1), a resin sheet is used and stretched on or over the screen frame.

In general, the gauze-stretching process is carried out by using a gauze-stretching device, etc. such as an air stretcher gauze-stretching device.

With respect to the tension applied to the resin sheet, it is generally set in the range of 0.3 to 3.0 mm, preferably 0.8 to 1.2 mm, when measured by a tension gauge (STG-75B made by Tokyo Process Service K.K.)

Then, in order to fix the resin sheet onto the screen frame, a bonding agent is generally applied between the two members. Since it takes normally approximately 5 minutes to 24 hours for the bonding agent to set, the superposed state is maintained as it is for such a period.

With respect to the bonding agent, any bonding agent may be used as long as it allows fixing; and in general, rubber-based or UV-setting bonding agents, etc. are used.

### (4) Punching process of the resin sheet

With respect to the punching process through the resin sheet stretched on or over the screen frame, it is important to carry it out by using a numerically controlled punching machine.

With respect to the above-mentioned numerically controlled punching machine, in general, those punching machines commercially available, such as a ceramic green sheet multi-punching machine and a multi-punching machine for a flexible print wiring board, are listed, and among these numerically controlled punching machines, the ceramic green sheet multi-punching machine is preferably used. The punching capability of these numerically controlled punching machines is in the range of 10 to 20 holes/sec. This capability is independent of the size and shape of a hole to be punched.

The punching process through the resin sheet is prepared by grabbing the screen frame on or over which the resin sheet is stretched with a clamp attached to the machine and setting it onto a machining base or by setting it on a predetermined jig, and setting the jig onto the machine base.

### Method for stretching the resin sheet on or over the screen frame after the resin-sheet punching process

### (i) Punching process of the resin sheet

In general, the punching process through the resin sheet is carried out by using the ceramic green sheet multi-punching machine through the same punching process as used for green sheets.

In other words, the punching process through the resin sheet is prepared by grabbing the resin sheet with a clamp attached to the machine and setting it onto a machining base, or by setting it on a predetermined jig with the resin sheet being preliminarily stretched on or over an aluminum frame and setting the jig onto the machine base.

The peripheral portion of the resin sheet is grabbed by the clamp attached to the machine so that the resin sheet is secured, and with a tension being given to the resin sheet, the resin sheet is subjected to a punching process by using a numerically controlled punching machine; this arrangement is preferably adopted.

The tension given to the resin sheet at this time is generally set in the range of 0.3 to 3.0 mm, preferably 1.5 to 2.5 mm (measured by a Tension Gauge STG-75B made by Tokyo Process Service K.K.).

With respect to the above-mentioned numerically controlled punching machine, in general, those punching machines commercially available, such as a ceramic green sheet multi-punching machine and a multi-punching machine for a flexible print wiring board, are listed, and among these numerically controlled punching machines, the ceramic green sheet multi-punching machine is preferably used.

In the case where the resin is processed to be a roll, in general, the punching process can be carried out in a roll-to-roll mode by using a multi-punching machine used for a flexible print wiring board, for example, a roll-to-roll RFP-24 made by UHT K.K.

### (ii) Mesh textile stretching process

With respect to the mesh textile stretching process for gauze-stretching the mesh textile on or over the screen frame, the same process as used in "(1) Mesh textile stretching process" is carried out. Here, (ii) mesh textile stretching process is carried out independent of (i) punching process of the resin sheet, and the processes (i) and (ii) may be carried out simultaneously or either of them may be preliminarily carried out.

### (iii) Mesh textile affixing process

The process for affixing the resin sheet punched by the numerically controlled punching machine (prepared in the process (i)) onto the mesh textile stretched on or over the screen frame (prepared in the process (ii)) is carried out in the same manner as the above-mentioned "(2) mesh textile affixing process" except that the punched resin sheet prepared in the process (i) is used as the resin sheet.

### (iv) Resin sheet stretching process

A portion (central portion), which is located inside the bonding agent-applied portion of the mesh textile on which the resin sheet has been laminated, is cut out so that the resin sheet is set in the screen frame through intermediary of the mesh textile.

In the case where the resin sheet is directly stretched on or over the screen frame without through the mesh textile, the resin sheet prepared in the process (i) is used in place of the mesh textile in the above-mentioned (ii) mesh textile stretching process, and stretched over the screen frame.

The gauze-stretching process is normally carried out by using a gauze-stretching device, etc. such as an air stretcher gauze-stretching device.

With respect to the tension given to the resin sheet, the fixing method, and the bonding agent, those which are the same as the case when the resin sheet is directly stretched on or over the screen frame without through the intermediary of the mesh in (3) resin sheet stretching process are used in the same manner.

As compared with the metal mask prepared by the electroforming method and the plastic mask prepared by the exima laser machining, the screen printing plate of the present invention is more easily subjected to the punching process; therefore, it is possible to manufacture a screen printing plate at low costs in a short time so as to meet the demands. In addition, the application of the screen printing plate of the present invention makes it possible to carry out printing on various materials with a sufficient thickness, and the printed materials are free from fog and blurredness.

In the present invention, in either of the cases where, after having been stretched on or over the screen frame, the resin sheet is punched and where, after having been punched, the resin sheet is stretched on or over the screen frame, upon stretching the resin sheet on or over the screen frame through the mesh textile, the resin sheet stretching process, in which a portion (central portion), which is located inside the bonding agent-applied portion of the mesh textile on which the resin sheet has been stacked, is cut out so that the resin sheet is stretched on or over the screen frame through the intermediary of the mesh textile, is not necessarily required; however, by providing this process, it is possible to avoid the mesh from being stretched over the holes, and consequently to provide the superior effect that no bubble is involved in the printed materials.

The following description discuss the present invention in detail by means of Examples and Comparative Examples:

### Example 1

On an aluminum screen frame having a length of 35 cm and a width of 35 cm was gauze-stretched a 225-mesh polyester screen (T225 made by Nippon Tokushu Orimono K.K.). On the central portion of this screen was bonded a polypenylsulfide film (Torelina* made by Toray Industries, Inc.) having a thickness of 150µm, a length of 15 cm and a width of 15 cm with a bonding agent. Then, the inside portion (central portion) (14 cm × 14 cm) of the mesh screen bonded to the film, was cut out so that a screen printing plate having a tension of 1.10 mm (measured by a tension gauze STG-75B made by Tokyo Process Service K.K.) was obtained (combination method).

This screen frame in which the polyphenylenesulfide film was affixed was set on a numerically controlled punching machine (a Ceramic Green Sheet Multi-Punching Machine MP-7150 made by UHT K.K.), and the film stretched in the screen frame was subjected to a punching process under the following conditions by using a punch unit having a punching diameter of 0.2 mm□:

### Punching conditions

- Punching rate:: 10 holes/sec.
- Feeding rate:: 30 cm/sec.
- Pin-die clearance:: 0.01 mm
- Pattern:: QFP pattern with 0.4 mm pitches

The shape of the hole after the punching process was free from burr, etc., and as a result of its application to a screen printing plate, the following performances were obtained. These performances are sufficiently satisfactory as a screen printing plate.

### Printing conditions:

- Printing machine:: MC 212 made by C.W.PLICE Co., Ltd.
- Paste:: Solder paste 0Z63-221CM5-42-10 made by Senjyu Kinzoku Kogyo K.K.
- Printing board:: One sided board made of paper-phenol

### Results of printing:

The shape of the printed solder paste was free from fog, blurredness, bubbles, etc., and it was possible to perform a continuous printing operation without causing damages to the board.

### Example 2

A composite resin sheet of polyphenylenesulfide and PET (TLT-240 made by Toray Industries, Inc.) having a thickness of 240µm, a length of 15 cm and a width of 15 cm was set on the numerically controlled punching machine (a Ceramic Green Sheet Multi-Punching Machine MP-7150 made by UHT K.K.) used in Example 1, and the film was subjected to a punching process under the following conditions by using a punch unit having a punching diameter of 0.5 mm□:

### Punching conditions

- Tension:: 2.0mm (Tension Gauge STG-75B made by Tokyo Process Service K.K.)
- Punching rate:: 10 holes/sec.
- Feeding rate:: 30 cm/sec.
- Pin-die clearance:: 0.01 mm
- Pattern:: Aggregate of resist patterns 2 mm × 20 mm

Then, in the same manner as described in Example 1, over an aluminum screen frame having a outer frame size of 350 mm × 350 mm was gauze-stretched a 225-mesh polyester screen (T225 made by Nippon Tokushu Orimono K.K.). On the central portion of this screen was bonded the composite resin sheet having a length of 15 cm and a width of 15 cm with a bonding agent. Then, the portion (central portion) (14 cm × 14 cm) of the mesh screen bonded to the film, was cut out so that a screen printing plate having a tension of 1.00 mm (measured by a Tension Gauze STG-75B made by Tokyo Process Service K.K.) was obtained (combination method).

The shape of the hole after the punching process was free from burr, etc., and as a result of the application as a screen printing plate, the following performances were obtained. These performances sufficiently satisfied the application as a screen printing plate.

### Printing conditions:

- Printing machine:: MC 212 made by C.W.PLICE Co., Ltd.
- Ink:: Thermosetting resist ink CCR (made by Asahi Chemical Laboratory K.K.)
- Printing board:: 6-inch silicon wafer

### Results of printing:

The shape of the printed resist ink sufficiently satisfied a desired ink thickness, and formed a superior resist coat film that was free from fog, blurredness, bubbles, etc., without causing any damages to the base member surface of the silicon wafer.

### Comparative Example 1

The same processes as Example 1 were carried out except that polyethyleneterephthalate resin film (Lumirror* made by Toray Industries, Inc.) having a thickness of 150µm was used in place of polyphenylene sulfide resin used in Example 1.

As a result, with respect to the shape of the hole after the punching process, burr resulted from fused resin, etc. appeared on the sheet surface, and this failed to provide a screen printing plate.

## Claims

1. A screen printing plate, characterized in that a sheet made of at least one kind of resin selected from the group consisting of polyimide resins, polyetherimide resins and polyphenylenesulfide resins is subjected to a punching process by a numerically controlled punching machine, and is set on or over, or in a screen frame.

2. The screen printing plate of claim 1, wherein the resin sheet is set in the screen frame through the intermediary of textile made of at least one kind of material selected from the group consisting of polyester, stainless steel, nylon and polyethylene, or a composite thereof.

3. A manufacturing method of a screen printing plate, characterized in that, after a sheet made of at least one kind of resin selected from the group consisting of polyimide resins, polyetherimide resins and polyphenylenesulfide resins has been stretched on or over, or in a screen frame, the resin sheet is subjected to a punching process by a numerically controlled punching machine.

4. A manufacturing method of a screen printing plate, characterized in that, after a sheet made from at least one kind of resin selected from the group consisting of poly imide resins, polyether imide resins and polyphenylenesulfide resins is clamped along its peripheral portion with a tension being applied thereto, the resin sheet is subjected to a punching process by a numerically controlled punching machine, and then set on or over, or in a screen frame.

5. The manufacturing method of a screen printing plate of claim 3 or 4, wherein the resin sheet is set in the screen frame through the intermediary of textile made of at least one kind of material selected from the group consisting of polyester, stainless steel, nylon and polyethylene, or a composite thereof.
